Europäisches Patentamt

(19) European Patent Office

Office européen des brevets

(11) Numéro de publication : **0 223 780**
**B1**

## (12) FASCICULE DE BREVET EUROPÉEN

(45) Date de publication du fascicule du brevet :
**28.03.90**

(21) Numéro de dépôt : **86902850.6**

(22) Date de dépôt : **13.05.86**

(86) Numéro de dépôt international :
**PCT/FR 86/00163**

(87) Numéro de publication internationale :
**WO/86071 (04.12.86 Gazettee 86/26)**

(51) Int. Cl.⁵ : **H 01 L 21/28**, H 01 L 21/82, H 01 L 21/31

(54) PROCEDE DE FABRICATION DE TRANSISTORS MOS A ELECTRODES DE SILICIURE METALLIQUE.

(30) Priorité : **21.05.85 FR 8507645**

(43) Date de publication de la demande :
**03.06.87 Bulletin 87/23**

(45) Mention de la délivrance du brevet :
**28.03.90 Bulletin 90/13**

(84) Etats contractants désignés :
**DE FR GB IT NL**

(56) Documents cités :
**EP–A– 0 124 960
EP–A–00 231 46
EP–A–01 064 58
IEEE Journal of Solid-State Circuits, volume SC-17, no. 2, april 1982, IEEE, New York, (US) P.J. Tsang and al.: "Fabrication of high-perfomance LDDFET's with oxide sidewall-spacer technology", pages 220-226
IEDM Technical Digest, International Electron Devices Meeting, Washington D.C., 7-8-9 December 1981, IEEE Technical Digest no. 28,2, New York, (US) T. Shibata and al.: "An optimally designed process for submicron MOSFET's", pages 647-650
Japanese Journal od Applied Physics, Supplement, Extended Abstracts of the 15th Conference on Solid-State Devices and Materials, 1983, Tokyo, (JP) A. Higashisaka and al.: "Sidewall-assisted closely spaced electrode technology for high-speed GaAs LSI's", pages 69-72**

(73) Titulaire : **SGS-THOMSON MICROELECTRONICS S.A.
7, Avenue Galliéni
F-94250 Gentilly (FR)**

(72) Inventeur : **ROCHE, Alain
13, av. Sainte Thérèse
F-38700 La Tronche (FR)**
Inventeur : **BOREL, Joseph
12, rue du Drac
F-38120 St. Egrève (FR)**
Inventeur : **BAUDRANT, Annie
52, rue J.J. Rousseau
F-38400 Saint Martin d'Hères (FR)**

(74) Mandataire : **Rinuy, Santarelli
14, avenue de la Grande Armée
F-75017 Paris (FR)**

## Description

La présente invention concerne un procédé de réalisation de circuits intégrés à haute densité d'intégration.

La densité d'intégration est d'autant plus élevée que les dimensions d'un transistor élémentaire sont plus petites. On cherche donc à réduire autant que possible ces dimensions, sans pour autant détériorer les qualités électriques des transistors réalisés.

De nombreux paramètres sont à prendre en compte pour obtenir de bonnes qualités électriques. Parmi ces paramètres, l'un au moins est spécialement défavorisé par la réduction des dimensions, et ce paramètre est la conductivité électrique des connexions du circuit, en particulier la conductivité électrique des connexions aboutissant aux grilles, sources et drains des transistors à effet de champ. Si le transistor doit être très petit, les contacts des électrodes de source et de drain avec les régions de source et de drain le seront également ; de même, la grille doit être très étroite. Mais alors l'aptitude des connexions à transmettre une densité de courant élevée diminue, ce qui est préjudiciable au bon fonctionnement du circuit.

C'est pourquoi, alors que les fabrications industrielles actuelles utilisent beaucoup le silicium polycristallin pour réaliser les électrodes de grille ainsi que des contacts de source et drain et certaines interconnexions, on cherche de plus en plus à recouvrir le silicium polycristallin d'une couche de siliciure métallique plus conducteur qui améliore beaucoup la conductivité globale des connexions pour des dimensions de conducteur données. La Demanderesse a d'ailleurs également essayé de réaliser des transistors ne comportant pas du tout de silicium polycristallin, transistors dont les électrodes de grille, de source et de drain, et les interconnexions de premier niveau, sont entièrement en siliciure métallique, plus conducteur que l'association silicium polycristallin/siliciure métallique.

Mais alors, il est souhaitable de prévoir des procédés de fabrication qui permettent effectivement une réduction des dimensions des transistors. En effet, si l'utilisation de siliciure métallique devait imposer des procédés de fabrication ne permettant pas d'aboutir à de très petites dimensions, on risquerait de reperdre en densité d'intégration ce qu'on aurait gagné en augmentation de conductivité.

En d'autres mots il est souhaitable bien sûr de réduire la résistivité des interconnexions, des contacts de source et de drain, et des électrodes de grille, mais il est également souhaitable de profiter de cette réduction de résistivité pour augmenter la densité d'intégration de certains circuits ou certaines parties de circuits.

Un autre aspect important de la présente invention résulte du fait que des électrodes en siliciure métallique reposant directement sur du silicium monocristallin permettent d'établir des contacts de type Schottky (métal/semiconducteur) qui présentent de l'intérêt dans certains cas. La notion de transistors à effet de champ à contacts Schottky pour la source et le drain est décrite dans l'article de M. P. Lepselter et S. M. Sze intitulé « An Insulated-Gate Field Effect Transistor Using Schottky Barrier Contacts as Source and Drain », publié dans « Proceedings of the IEEE Vol 56, Aug. 1968, pages 1400-1402 ».

Le problème technique qui se pose pour ces transistors Schottky est la nécessité de rapprocher au maximum le contact de source (ou de drain) de la grille, faute de quoi un intervalle existe entre la source proprement dite (ou le drain) et le canal contrôlé par la grille, et le transistor ne peut être rendu conducteur convenablement.

La présente invention propose un procédé de fabrication qui permet de rapprocher beaucoup le contact de source (ou de drain) de la grille, et par conséquent qui permet non seulement de réaliser de manière commode et efficace un transistor à effet de champ à contacts Schottky, mais aussi plus généralement de réduire au minimum les dimensions des transistors, qu'ils soient Schottky ou non Schottky.

Le procédé de fabrication de transistors à effet de champ selon l'invention comprend les étapes principales suivantes :

a) formation de zones actives de silicium monocristallin séparées les unes des autres par des zones d'isolant,

b) formation sur les zones actives d'une couche isolante mince constituant l'isolant de grille des transistors,

c) dépôt uniforme d'une couche de siliciure métallique,

d) photogravure du siliciure selon un motif laissant subsister les grilles des transistors,

e) implantation ionique d'impuretés pour la formation de régions de drain et de source autoalignées avec les grilles,

f) formation sur toute la surface active, ainsi que sur les parois verticales et horizontales des grilles, d'une deuxième couche isolante,

g) gravure anisotrope verticale de cette deuxième couche isolante, jusqu'à mise à nu du silicium de la zone active en dehors des grilles des transistors, en laissant subsister un remblai (ou ruban) d'isolant contre les parois verticales des grilles,

h) dépôt uniforme d'une deuxième couche de siliciure métallique,

i) dépôt d'une couche essentiellement plane d'une substance pouvant être gravée à la même vitesse que le siliciure de tantale,

j) gravure uniforme de cette substance jusqu'à enlèvement total, avec gravure simultanée de la deuxième couche de siliciure là où elle présente des parties surélevées, la gravure se poursuivant jusqu'à l'obtention d'une structure dans laquelle le siliciure de la première couche et celui de la deuxième couche sont totalement séparés électriquement par le remblai isolant.

Dans cette succession d'étapes qui résument le déroulement global des opérations de fabrication, il faut porter une attention plus particulière à la combinaison des points fondamentaux suivants :

— tout d'abord il est essentiel de remarquer que la grille est réalisée par une première couche de siliciure métallique, tandis que les électrodes de source et de drain sont réalisées par une deuxième couche de siliciure métallique ;

— ensuite, alors que la première couche de siliciure est gravée selon un procédé de photogravure classique définissant les connexions de grilles, la deuxième couche est gravée selon un processus de gravure uniforme planarisante, c'est-à-dire un processus qui d'une part se fait sans masque de gravure et qui d'autre part élimine les reliefs à la surface du substrat (en particulier les reliefs créés par le recouvrement de la deuxième couche sur les motifs de la première couche). C'est par cette gravure uniforme planarisante que les deux couches de siliciure métallique sont clairement séparées, un remblai d'isolation électrique ayant été prévu sur les bords latéraux des grilles après la formation du motif de grilles.

D'autres caractéristiques et avantages de l'invention apparaîtront à la lecture de la description détaillée qui suit et qui est faite en référence aux dessins annexés dans lesquels les figures 1 à 10 représentent les étapes successives principales d'un premier mode de fabrication selon l'invention, et les figures 11 et 12 représentent des modifications apportées par l'utilisation d'un deuxième mode de fabrication.

L'invention sera décrite principalement à propos d'un transistor MOS à canal N, non Schottky, mais elle est applicable à d'autres cas et notamment à des transistors à canal P, à des transistors complémentaires N et P sur le même substrat, Schottky ou non Schottky.

On part d'un substrat 10 de silicium monocristallin de type P (par exemple) dans lequel on veut faire des transistors à effet de champ à canal N. Pour des transistors à canal P on partirait d'un substrat de type N. Pour des transistors complémentaires N et P sur le même substrat on réaliserait des caissons de type opposé au substrat, les transistors d'un premier type étant formés dans les caissons et ceux du type complémentaire étant formés directement dans le substrat en dehors des caissons.

On définit des zones actives A isolées les unes des autres par des zones d'isolant épais B.

Par exemple, par un procédé d'oxydation épaisse localisée, on réalise autour d'une zone active A un mur d'oxyde de silicium épais 12' (épaisseur d'un micromètre par exemple).

L'oxyde épais s'étend en hauteur plus haut que la surface supérieure 14 de la zone active et en profondeur plus bas que cette surface. Un certain relief est donc créé sur la surface supérieure du substrat.

On notera qu'avant ou après cette formation de zones actives entourées des murs 12 on peut effectuer des opérations classiques non décrites ici, telles qu'une implantation de champ de type P+ au-dessous des murs épais 12 (zone 16), ou encore des implantations de déplétion ou d'enrichissement dans les zones actives, ou encore une implantation profonde pour la réalisation des caissons dans le cas de transistors MOS complémentaires.

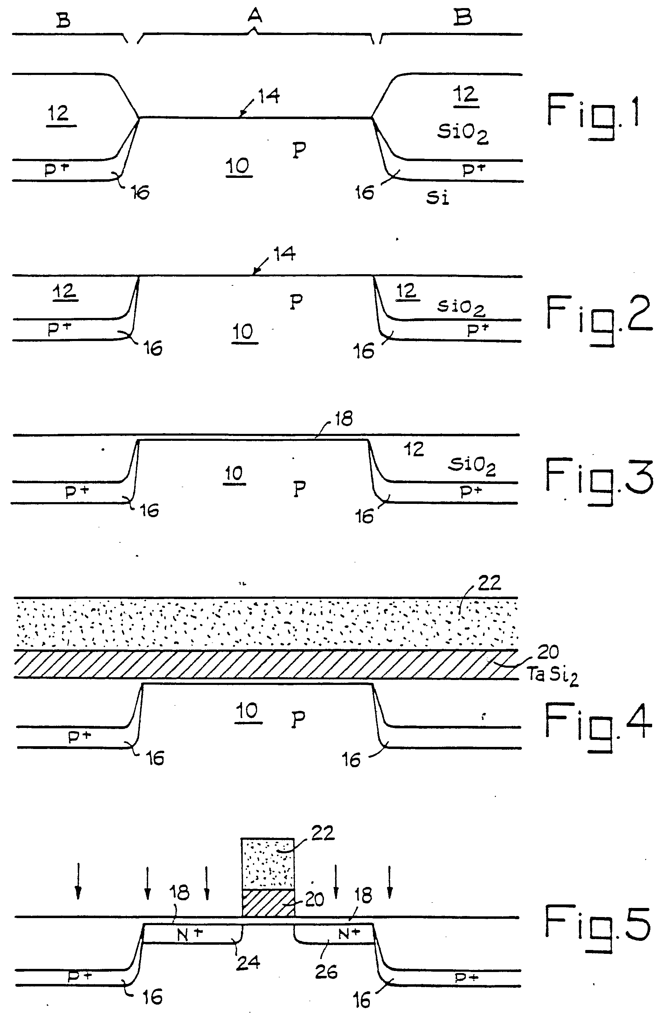

On rabote alors la partie des murs d'isolation qui dépasse au-dessus de la surface supérieure 14 de la zone active A, de manière à faire affleurer les murs à la même hauteur que le silicium monocristallin, l'isolation entre zones actives se faisant par la partie enfoncée des murs (figure 2).

Pour effectuer une planarisation de la surface du substrat, on effectue un dépôt à surface plane de résine ou de verre en suspension dans une solution basique (« spin-on glass »), la résine et la composition du verre étant choisies telles qu'elles puissent être attaquées par un produit de gravure approprié à la même vitesse que l'oxyde des murs 12. Le dépôt de la résine ou du verre en suspension est effectué par centrifugation pour obtenir une surface supérieure plane.

Après cela on grave uniformément (c'est-à-dire sans masque) la surface supérieure de la tranche pendant un temps suffisant pour enlever toute l'épaisseur de la résine. La gravure est une gravure au plasma avec un composé fluoré (par exemple $CHF_3$) additionné d'un pourcentage d'oxygène (par exemple 9 %).

On aboutit alors à une structure plane telle que celle de la figure 2.

Dans une variante de procédé, on verra que l'on peut se dispenser de cette planarisation et conserver la structure de départ de la figure 1 avec le relief créé par les zones d'oxyde épais 12.

L'étape suivante consiste à former sur toute la surface de la zone active A une couche mince isolante 18 qui servira d'isolant de grille aux transistors à effet de champ à grille isolée. Cette couche est de préférence réalisée par oxydation thermique de la surface du silicium. Son épaisseur est de quelques dizaines de nanomètres (Figure 3).

Dans certains cas on pourra graver sélectivement la couche d'oxyde mince après cette étape, pour dénuder le silicium monocristallin à certains endroits du substrat. Pour l'essentiel cependant les zones actives resteront recouvertes de la couche isolante mince 18.

On dépose alors uniformément une couche de siliciure métallique, par exemple du siliciure de tantale $TaSi_2$, d'une épaisseur de quelques centaines de nanomètres. L'épaisseur de dépôt sera choisie supérieure, de quelques dizaines de nanomètres au moins, à l'épaisseur finale désirée pour les grilles des transistors. Par exemple, pour une épaisseur finale de grille de 200 nm, on choisira un dépôt de 300 nm. Le siliciure est déposé par exemple par pulvérisation d'une cible de siliciure de tantale frittée.

On dépose ensuite une couche de résine photosensible 22 (qui peut être une résine multicouche apte à la définition de motifs très étroits).

La résine 22 est exposée à travers un masque définissant un motif de grille et elle est développée pour ne laisser subsister la résine dans les zones actives qu'à l'emplacement des grilles mais non à l'emplacement des régions de source et drain. La résine développée est capable de résister aux produits de gravure du siliciure de tantale.

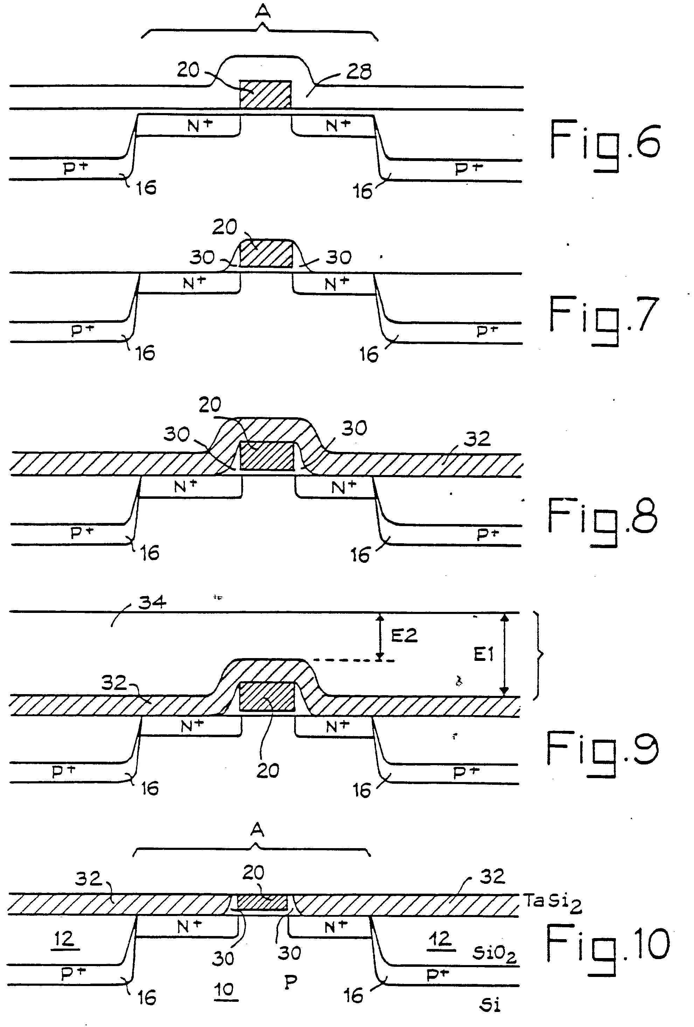

On grave alors, par exemple à l'aide d'un plasma chloré, le siliciure de tantale, de manière à l'éliminer là où il n'est pas protégé par la résine (Figure 5).

Avant d'enlever la résine 22 ou après l'avoir enlevée, on effectue une implantation ionique d'impuretés de type N+ pour définir des régions de source 24 et de drain 26 des transistors (à canal N).

Les régions de source et de drain sont de ce fait autoalignées par rapport à la grille de siliciure de tantale.

Pour un transistor MOS normal (contacts non Schottky) l'implantation se fera avec une dose et une énergie moyenne correspondant à ce qui se fait usuellement pour des transistors à grille de silicium polycristallin. Pour des transistors à contacts Schottky de source et drain, l'implantation sera superficielle et donc à faible dose et faible énergie.

Par exemple, pour un transistor Schottky à canal N, on peut implanter de l'arsenic avec une énergie de 50 à 80 keV et une dose de $10^{12}$ à $10^{13}$ atomes/cm² en obtenant une profondeur de jonction de 80 à 120 nm environ. La résistivité de la couche superficielle N+ est alors de l'ordre de 1 à 0,1 ohms-cm.

Pour un transistor Schottky à canal P, formé dans un caisson N, on peut implanter du bore avec une énergie d'environ 25 keV à partir d'une dose de bore de quelques $10^{12}$ atomes/cm². La profondeur de jonction est de 250 nm environ et la résistivité de 0,1 ohms-cm ; on peut aussi implanter du bore à partir de fluorure de bore avec une énergie de 25 à 50 keV (profondeur de jonction d'environ 100 nm).

Si la résine n'a pas été éliminée avant l'implantation, on l'élimine et on dépose uniformément une couche de substance isolante 28, par exemple de l'oxyde de silicium. Le dépôt est fait en phase vapeur à basse pression, de manière à obtenir un bon recouvrement de la surface y compris à l'endroit des marches abruptes de siliciure de tantale 20 (figure 6) ; le dépôt peut être assisté par plasma (« plasma enhanced deposition »).

L'épaisseur de cette couche 28 est d'environ 100 nm. On verra que cette épaisseur règle l'espacement entre la grille et les électrodes de source et de drain.

On grave alors uniformément (sans masque) la couche 28 sur toute son épaisseur, par une méthode de gravure anisotrope verticale (par exemple une gravure ionique réactive à l'aide d'un plasma de CHF₃). On arrête la gravure lorsque la surface de silicium monocristallin de la zone active A est dénudée. Des remblais isolants 30 subsistent alors de part et d'autre de la grille de siliciure de tantale 20 ; ces remblais sont le reliquat de la gravure uniforme verticale de la couche d'oxyde 28 ; en pratique ils forment un ruban isolant tout autour des bords latéraux de la grille.

On dépose alors une deuxième couche 32 de siliciure métallique (siliciure de tantale). Cette couche 32 recouvre la première et recouvre également le silicium monocristallin dans les régions de source et de drain. Elle recouvre également les murs d'oxyde épais. Elle s'appuie sur les remblais isolants 30 aux endroits où la couche 32 remonte au-dessus de la première couche de siliciure de tantale 20.

L'épaisseur de la deuxième couche de siliciure de tantale est plus faible que celle de la première couche. Elle est par exemple de 200 nm pour une épaisseur de 300 nm de la première couche.

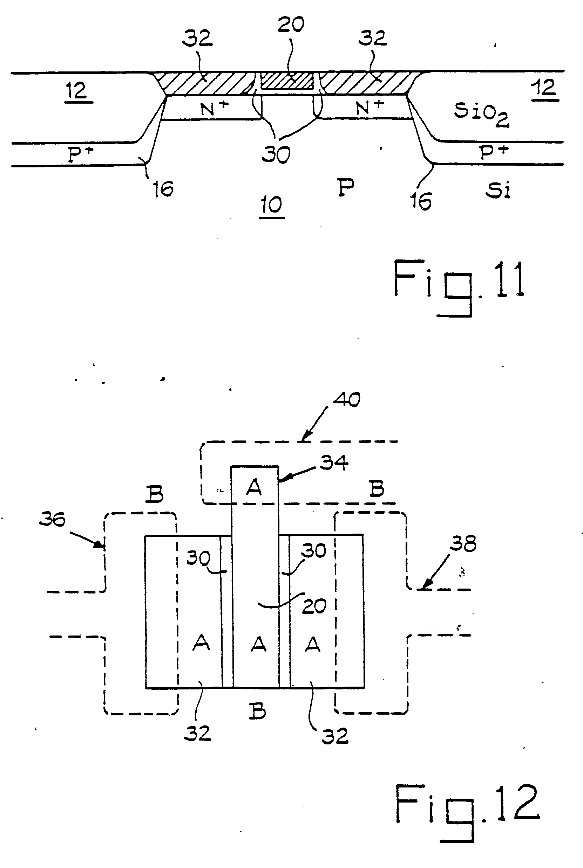

On dépose alors uniformément sur toute la surface du substrat une couche 34 de matière planarisante, par exemple du verre en suspension (« spin-on » glass), déposée de préférence par centrifugation de manière à obtenir une surface plane pour cette couche. On pourrait envisager comme autre dépôt de matière planarisante un dépôt de polyimide fluide (par centrifugation) ou une pulvérisation cathodique d'oxyde de silicium avec pulvérisations inverses alternées avec les pulvérisations directes (Figure 9).

En tout cas la substance déposée doit avoir comme propriété de pouvoir être gravée en même temps que le siliciure métallique de la première couche, et à la même vitesse que celui-ci, en utilisant un produit d'attaque commun.

Après dépôt de cette couche 34 on effectue une gravure uniforme du substrat pour éliminer cette couche sur toute son épaisseur E1 et éliminer par la même occasion le siliciure de tantale de la deuxième couche 32 là où il remonte au-dessus de la première couche 20.

Le plus simple est d'arrêter la gravure simultanée de la couche 34 lorsque la totalité de cette couche a disparu.

Une gravure au plasma avec un mélange de composés chloré et fluoré permet d'attaquer à la même vitesse le verre en suspension et le siliciure de tantale. L'arrêt de la gravure pourra être effectué lors de la détection spectrométrique de la disparition de la raie CO dans le spectre d'émission des produits résultant de la gravure. Cette disparition indique que la deuxième couche de siliciure de tantale (qui recouvre la quasi-totalité du substrat) est mise à nu.

Lorsqu'on arrête ainsi la gravure, on aboutit à la structure de la figure 10 dans laquelle la deuxième couche 32 de siliciure subsiste sur la majeure partie de la surface du substrat, mais a été éliminée là où elle recouvrait la première couche, c'est-à-dire au-dessus des grilles.

Les grilles subsistent également, avec une épaisseur réduite essentiellement à l'épaisseur de la première couche.

La première couche 20 et la deuxième couche 32 de siliciure sont parfaitement isolées l'une de l'autre grâce aux remblais 30 qui les séparaient latéralement.

La surface finale du substrat à cette étape est pratiquement plane.

La dimension élémentaire du transistor, prise dans le sens de la longueur du canal se réduit à la somme des dimensions suivantes :

— largeur de la grille qui peut être celle que permet la résolution optique en photolithographie : de l'ordre de un micromètre,

— largeur des remblais : deux fois 100 nm environ,

— largeur minimale nécessaire aux contacts de source et drain, sachant que cette largeur doit tenir compte des tolérances de positionnement de la grille au centre de la zone active : deux fois 1,2 micromètre environ.

Au total on aboutit à un transistor de largeur inférieure à quatre micromètres.

En revenant à la figure 9, pour préciser le procédé de gravure de la couche 34 et des zones surélevées de siliciure de tantale, on peut envisager de réaliser la gravure en deux temps.

Dans un premier temps, seule la couche 34 doit être attaquée. On peut effectuer une gravure ionique réactive rapide au plasma fluoré ($CHF_3$ ou $CHF_3 + O_2$) sur une épaisseur presque égale à l'épaisseur E2 de la couche 34 au-dessus des zones surélevées de siliciure de tantale.

Dans un deuxième temps on a besoin d'une gravure simultanée, à la même vitesse, de la couche 34 et du siliciure. On effectue une gravure lente au plasma avec un mélange de composés fluorés ($SF_6$) et chlorés ($Cl_2$).

La structure de la figure 10 étant obtenue, il est nécessaire de procéder à une photogravure du siliciure métallique pour définir un motif d'interconnexions plus précis entre les zones actives ; en effet, au stade de la figure 10, la totalité de la tranche est recouverte de siliciure des première et deuxième couches, les zones de siliciure de la première couche étant partout entourées d'un remblai isolant qui les sépare des zones de la deuxième couche. La gravure du siliciure aura pour but par exemple de séparer deux portions de deuxième couche qui sont initialement réunies et qui ne devraient pas l'être dans le circuit final.

La fabrication du circuit peut se poursuivre par d'autres opérations telles que des dépôts isolants, des réalisations d'interconnexions sur d'autres niveaux et en matériaux conducteurs différents, une passivation etc...

Dans le cas de la fabrication de transistors CMOS il faut prévoir que certaines opérations soient dédoublées pour être faites indépendemment du côté des transistors à canal N et du côté des transistors à canal P. En particulier, si l'implantation de source et de drain faite à la figure 5 doit être faite en présence de la résine 22, il est nécessaire que la gravure du siliciure de la première couche 20 soit faite en deux étapes distinctes pour les grilles de transistors à canal N et à canal P, chaque étape étant suivie d'une implantation respective N ou P.

Si l'implantation se fait avec un masquage uniquement par les grilles de siliciure elles-mêmes (la résine 22 ayant été enlevée), la gravure du siliciure peut être faite en une seule étape, mais l'implantation est faite en deux étapes, les transistors d'un type de canal étant globalement masqués par une résine pendant l'implantation de source et drain des transistors de l'autre type de canal.

Dans une variante de réalisation du procédé selon l'invention, on supprime l'étape correspondant à la figure 2, c'est-à-dire qu'on garde le relief non plan créé par les zones d'oxyde épais 12 (figure 1). On exécute alors exactement les mêmes opérations que celles qui ont été décrites en référence aux figures 3 à 10 ; seul le résultat obtenu diffère : dans la structure de la figure 10, le siliciure 32 de la deuxième couche recouvre la quasi-totalité du substrat, tandis que le siliciure 20 de la première couche recouvre le reste, les deux couches étant séparées latéralement par le remblai isolant 30 ; dans la structure de la figure 11, les zones d'oxyde épais 12 sont dépourvues de siliciure et c'est seulement dans les zones actives A que l'on rencontre du siliciure 32 de la deuxième couche au-dessus des zones de source et drain et du siliciure 20 de la première couche pour constituer la grille, avec toujours un remblai isolant 30 séparant latéralement les siliciures des deux couches. Cette structure de la figure 11 résulte directement de l'application du procédé déjà décrit lorsqu'on supprime l'étape de planarisation de l'oxyde épais 12 en début de procédé. On remarque que le siliciure de la deuxième couche, comme d'ailleurs celui de la première couche, ne peut plus servir à l'interconnexion de différents transistors entre eux car le siliciure est strictement localisé à l'intérieur des zones actives. Il faut alors prévoir une couche d'interconnexion supplémentaire. Comme par ailleurs la grille sera en général très étroite elle ne permettra que difficilement la prise d'un contact entre grille et couche d'interconnexion supplémentaire ; c'est pourquoi on prévoira de préférence que la grille comporte, comme on le voit sur la vue de dessus de la figure 12, un prolongement 34, en dehors de l'espace qui sépare la source du drain, ce prolongement étant situé dans la zone active A c'est-à-dire au-dessus de l'oxyde mince. On pourra ainsi prévoir des contacts de conducteurs 36, 38, 40 respectivement (en pointillés) avec les électrodes de source, de drain, et de grille. Dans la pratique la forme du prolongement 34 sera établie par le masque définissant les zones actives A et B (la zone A présentera le prolongement 34 en plus du rectangle correspondant au transistor proprement dit). Le masque définissant la grille 20 aura quant à lui également une extension recouvrant totalement la région 34, le débordement éventuel disparaissant lors de la gravure planarisante de la deuxième couche de siliciure.

**Revendications**

1. Procédé de fabrication de transistors à effet de champ à grille isolée, comprenant la succession des étapes suivantes :

a) formation de zones actives de silicium monocristallin (A) séparées les unes des autres par des zones d'isolant (B),

b) formation sur les zones actives d'une couche isolante mince (18) constituant l'isolant de grille des transistors (Fig. 3),

c) dépôt uniforme d'une couche de siliciure métallique (20, Fig. 4),

d) photogravure du siliciure (20) selon un motif laissant subsister les grilles des transistors (Fig. 5),

e) implantation ionique d'impuretés pour la formation de régions de drain (26) et de source (24) autoalignées avec les grilles (Fig. 5),

f) formation sur toute la surface active, ainsi que sur les parois verticales et horizontales des grilles, d'une deuxième couche isolante (28, Fig. 6),

g) gravure anisotrope verticale de cette deuxième couche isolante, jusqu'à mise à nu du silicium de la zone active en dehors des grilles des transistors, en laissant subsister un remblai (30) d'isolant contre les parois verticales des grilles (Fig. 7),

h) dépôt uniforme d'une deuxième couche (32) de siliciure métallique (Fig. 8),

i) dépôt d'une couche essentiellement plane (34) d'une substance pouvant être gravée à la même vitesse que le siliciure de tantale (Fig. 9),

j) gravure uniforme de cette substance jusqu'à enlèvement total, avec gravure simultanée de la deuxième couche de siliciure là où elle présente des parties surélevées, la gravure se poursuivant jusqu'à l'obtention d'une structure dans laquelle le siliciure de la première couche (20) et celui de la deuxième couche (32) sont totalement séparés électriquement par le remblai isolant (Fig. 10).

2. Procédé de fabrication de transistors à effet de champ à grille isolée selon la revendication 1, caractérisé en ce que le siliciure métallique est du siliciure de tantale TaSi₂.

3. Procédé de fabrication de transistors à effet de champ à grille isolée selon la revendication 1, caractérisé en ce que l'étape a) comprend une oxydation épaisse localisée suivie d'une planarisation de la surface des murs d'isolation par gravure de l'oxyde épais aux endroits où il est surélevé par rapport à la surface des zones actives.

4. Procédé de fabrication de transistors à effet de champ à grille isolée selon la revendication 1, caractérisé en ce que l'implantation ionique d'impuretés de l'étape e) est réalisée avec une dose et une énergie suffisamment faibles pour établir ultérieurement un contact Schottky entre la deuxième couche de siliciure métallique et le silicium monocristallin des zones actives.

5. Procédé de fabrication de transistors à effet de champ à grille isolée selon la revendication 1, caractérisé en ce que l'implantation ionique de l'étape e) est réalisée en utilisant comme masque le motif de grille de siliciure de la première couche recouvert d'une résine photosensible servant par ailleurs à la définition du motif de grille lors de la photogravure de l'étape d).

6. Procédé de fabrication de transistors à effet de champ à grille isolée selon la revendication 1, caractérisé en ce que la substance déposée à l'étape i) est du verre en suspension.

7. Procédé de fabrication de transistors à effet de champ à grille isolée selon la revendication 6, caractérisé en ce que la gravure de l'étape j) est une gravure par plasma avec un mélange d'un composé chloré et d'un composé fluoré.

8. Procédé de fabrication de transistors à effet de champ à grille isolée selon la revendication 7, caractérisé en ce que le mélange comprend du chlore Cl₂.

9. Procédé de fabrication de transistors à effet de champ à grille isolée selon la revendication 1, caractérisé en ce que l'épaisseur de dépôt de la première couche de siliciure de tantale est supérieure à l'épaisseur de la deuxième couche.

10. Procédé de fabrication selon la revendication 1, dans lequel l'étape a) comprend une oxydation épaisse localisée conduisant à une surface du substrat non plane dans laquelle les zones actives (A) sont en creux et les zones d'isolant (B) sont en relief, caractérisé en ce que la zone active comprend une région de transistor proprement dit source, drain et grille, et une extension (34) de la grille au-dessus d'une zone d'oxyde mince en dehors de l'espace séparant une région de source d'une région de drain, cette extension permettant la prise d'un contact avec une couche d'interconnexion entre transistors.

**Claims**

1. Process for the manufacture of field effect transistors with an insulated grid, comprising the following series of stages :

a) formation of active regions of monocrystalline silicon (A) which are separated from each other by regions of insulator (B),

b) formation on the active regions of a thin insulating layer (18) constituting the grid insulator of the transistors (Fig. 3),

c) uniform deposition of a metal silicide layer (20, Fig. 4),

d) photoetching of the silicide (20) according to a pattern allowing the grids of the transistors to remain (Fig. 5),

e) ion implantation of impurities for the formation of drain (26) and source (24) regions which are self-aligned with the grids (Fig. 5),

f) formation of a second insulating layer (28, Fig. 6) over the whole active surface and on the vertical and horizontal walls of the grids,

g) vertical anisotropic etching of this second insulating layer to reveal the silicon in the active region outside the transistor grids, allowing an embankment (30) of insulator to remain against the vertical walls of the grids (Fig. 7),

h) uniform deposition of a second metal silicide layer (32) (Fig. 8),

i) deposition of an essentially planar layer (34) of a substance capable of being etched at the same rate as tantalum silicide (Fig. 9),

j) uniform etching of this substance until completely removed, with simultaneous etching of the second silicide layer where it exhibits raised portions, the etching being continued until a structure is obtained in which the silicide of the first layer (20) and that of the second layer (32) are completely separated electrically by the insulating embankment (Fig. 10).

2. Process for the manufacture of field effect transistors with an insulated grid according to Claim 1, characterized in that the metal silicide is tantalum silicide TaSi$_2$.

3. Process for the manufacture of field effect transistors with an insulated grid according to Claim 1, characterized in that stage a) comprises a localized thick oxidation followed by an operation of making the surface of the insulation walls planar by etching the thick oxide in places where it is raised relative to the surface of the active regions.

4. Process for the manufacture of field effect transistors with an insulated grid according to Claim 1, characterized in that the ion implantation of impurities in stage e) is carried out with a dose and an energy which are sufficiently low to subsequently establish a Schottky contact between the second metal silicide layer and the monocrystalline silicon of the active regions.

5. Process for the manufacture of field effect transistors with an insulated grid according to Claim 1, characterized in that the ion implantation in stage e) is carried out by using as a mask the silicide grid pattern of the first layer coated with a photosensitive resin serving, furthermore, to define the grid pattern during the photoetching in stage d).

6. Process for the manufacture of field effect transistors with an insulated grid according to Claim 1, characterized in that the substance deposited in stage i) is glass in suspension.

7. Process for the manufacture of field effect transistors with an insulated grid according to Claim 6, characterized in that the etching in stage j) is plasma etching with a mixture of a chlorine compound and of a fluorine compound.

8. Process for the manufacture of field effect transistors with an insulated grid according to Claim 7, characterized in that the mixture contains chlorine Cl$_2$.

9. Process for the manufacture of field effect transistors with an insulated grid according to Claim 1, characterized in that the thickness of deposit of the first tantalum silicide layer is greater than the thickness of the second layer.

10. Process of manufacture according to Claim 1, in which stage a) comprises a localized thick oxidation resulting in a nonplanar substrate surface in which the active regions (A) are in recess and the insulator regions (B) are in relief, characterized in that the active region comprises an actual transistor region, source, drain and grid, and an extension (34) of the grid above a thin oxide region outside the space separating a source region from a drain region, this extension permitting the setting up of a contact with an interconnection layer between transistors.

**Patentansprüche**

1. Verfahren zur Herstellung von Feldeffekttransistoren mit isolierter Steuerelektrode, das die Abfolge folgender Verfahrensschritte aufweist:

a) Bilden von Aktivzonen aus monokristallinem Silicium (A), die voneinander durch Isolationszonen (B) getrennt sind;

b) Bilden einer dünnen Isolationsschicht (18) auf den Aktivzonen, welche die Isolierung der Steuerelektrode der Transistoren darstellt (Fig. 3);

c) gleichmäßiges Aufbringen einer Metall-Silicid-Schicht (20) (Fig. 4);

d) Photoätzen des Silicids (20) nach einem Muster, bei dem die Steuerelektroden der Transistoren stehen bleiben (Fig. 5);

e) Ionenimplantation von Verunreinigungen zur Bildung von mit den Steuerelektroden ausgerichteten Drain- (26) und Source-Bereichen (24) (Fig. 5);

f) Bilden einer zweiten Isolierschicht (28) sowohl auf der gesamten aktiven Oberfläche als auch an den vertikalen und horizontalen Abschnitten der Steuerelektroden (Fig. 6);

g) vertikales anisotropes Ätzen dieser zweiten Isolierschicht bis zur Aufschließung des Siliciums der Aktivzone außerhalb der Steuerelektroden der Transistoren, wobei man eine Anböschung (30) zur Isolierung gegen die vertikalen Abschnitte der Steuerelektroden stehen läßt (Fig. 7);

h) gleichmäßiges Aufbringen einer zweiten Schicht (32) aus Metall-Silicid (Fig. 8);

i) Aufbringen einer im wesentlichen ebenen Schicht (34) einer Substanz, die mit derselben Geschwindigkeit wie Tantalsilicid geätzt werden kann (Fig. 9);

j) gleichmäßiges Ätzen dieser Substanz bis zur völligen Beseitigung, unter gleichzeitigem Ätzen der zweiten Silicid-Schicht an der Stelle, wo sie erhöhte Abschnitte aufweist, wobei die Ätzung solange durchgeführt wird, bis eine Struktur erhalten wird, in der das Silicid der ersten Schicht (20) und das der zweiten Schicht (32) durch die isolierende Anböschung vollständig elektrisch getrennt sind (Fig. 10).

2. Verfahren zur Herstellung von Feldeffekttransistoren mit isolierter Steuerelektrode nach Anspruch 1, dadurch gekennzeichnet, daß das Metall-Silicid Tantalsilicid TaSi$_2$ ist.

3. Verfahren zur Herstellung von Feldeffekttransistoren mit isolierter Steuerelektrode nach Anspruch 1, dadurch gekennzeichnet, daß Verfahrensschritt a) eine starke lokale Oxidation umfaßt, gefolgt von einer Einebnung der Oberfläche der Isolationswände durch Ätzung des starken Oxids und zwar an den Stellen, an denen das Oxid bezüglich der Oberfläche der Aktivzonen erhöht ist.

4. Verfahren zur Herstellung von Feldeffekttransistoren mit isolierter Steuerelektrode nach Anspruch 1, dadurch gekennzeichnet, daß die Ionenimplantation nach Verfahrensschritt e) mit einer Dosierung und einer Energie durchgeführt wird, die schwach genug sind, um später einen Schottky-Kontakt zwischen der zweiten Schicht aus Metall-Silicid und dem monokristallinen Silicium der Aktivzonen herzustellen.

5. Verfahren zur Herstellung von Feldeffekttransistoren mit isolierter Steuerelektrode nach Anspruch 1, dadurch gekennzeichnet, daß die Ionenimplantation nach Verfahrensschritt e) durchgeführt wird, indem man als Maske das Muster der Steuerelektrode des Silicids der ersten, von einem photosensitiven Harz bedeckten Schicht nutzt, das im übrigen zur Definition des Musters der Steuerelektrode bei der Photoätzung gemäß dem Verfahrensschritt d) dient.

6. Verfahren zur Herstellung von Feldeffekttransistoren mit isolierter Steuerelektrode nach Anspruch 1, dadurch gekennzeichnet, daß die aufgebrachte Substanz nach Verfahrensschritt i) Glas in Suspensionsform ist.

7. Verfahren zur Herstellung von Feldeffekttransistoren mit isolierter Steuerelektrode nach Anspruch 6, dadurch gekennzeichnet, daß die Ätzung nach Verfahrensschritt j) eine Plasmaätzung mit einer Mischung einer Chlor- und einer Fluorverbindung ist.

8. Verfahren zur Herstellung von Feldeffekttransistoren mit isolierter Steuerelektrode nach Anspruch 7, dadurch gekennzeichnet, daß die Mischung Chlor $Cl_2$ aufweist.

9. Verfahren zur Herstellung von Feldeffekttransistoren mit isolierter Steuerelektrode nach Anspruch 1, dadurch gekennzeichnet, daß die Schichtdicke der ersten Schicht aus Tantalsilicid größer ist als die Schichtdicke der zweiten Schicht.

10. Verfahren zur Herstellung von Feldeffekttransistoren mit isolierter Steuerelektrode nach Anspruch 1, bei dem Verfahrensschritt a) eine starke lokale Oxidation umfaßt, die zu einer Oberfläche eines nicht ebenen Substrats führt, auf der die Aktivzonen (A) vertieft und die Isolierzonen (B) hervorgehoben sind, dadurch gekennzeichnet, daß die Aktivzone einen Transistorbereich, sei es Source-, Drain- oder Gate-Bereich, und eine Ausdehnung (34) der Steuerelektrode über eine dünne Oxidzone außerhalb des Bereichs, der den Source- vom Drain-Bereich trennt, umfaßt wobei diese Ausdehnung eine Kontaktverbindung mit einer Zwischenverbindungsschicht zwischen Transistoren erlaubt.

EP 0 223 780 B1

**Fig.1**

**Fig.2**

**Fig.3**

**Fig.4**

**Fig.5**

Fig.6

Fig.7

Fig.8

Fig.9

Fig.10

32    20    32

12              N⁺              N⁺              SiO₂    12

P⁺                                                    P⁺

30

16              10              P              16      Si

Fig.11

40

34

B              A              B

36                                              38

30    30

20

A    A    A

B

32    32

Fig.12

3